# FASCICULE DE BREVET EUROPEEN

(11) **EP 3 364 513 B1**
(45) Date de publication et mention de la délivrance du brevet: **20.07.2022**
(21) Numéro de dépôt: 17204690.6
(22) Date de dépôt: 30.11.2017
(51) Int. Cl.: H02J 3/00, H02J 9/06, H02J 9/08

(54) **PROCÉDÉ DE CONTRÔLE D'UN INVERSEUR DE SOURCES ET INVERSEUR DE SOURCES METTANT EN OEUVRE UN TEL PROCÉDÉ**
KONTROLLVERFAHREN EINES QUELLENUMSCHALTERS, UND QUELLENUMSCHALTER, DER DIESES VERFAHREN ANWENDET
METHOD FOR MONITORING A SOURCE CHANGEOVER SWITCH AND SOURCE CHANGEOVER SWITCH IMPLEMENTING SUCH A METHOD

(30) Priorité: 17.02.2017 FR 1751279
(43) Date de publication de la demande: 22.08.2018
(73) Titulaire: Schneider Electric Industries SAS, 92500 Rueil-Malmaison (FR)
(72) Inventeur: RET, Alain, 38050 GRENOBLE (FR); NEYRET, Yannick, 38050 GRENOBLE (FR); NEREAU, Jean-Pierre, 38050 GRENOBLE (FR); HYPOLITE, Jean-Marie, 38050 GRENOBLE (FR)
(74) Mandataire: Lavoix

(56) Documents cités:
- WO-A2-2012/072526
- US-A- 5 739 594
- US-A1- 2004 124 710
- US-A1- 2010 019 574
- US-B1- 8 193 662
- US-B1- 9 225 202

## Description

### DOMAINE TECHNIQUE

L'invention concerne un procédé de contrôle d'un inverseur de sources destiné à connecter des sources d'énergie électrique à des charges électriques en fonction de la disponibilité desdites sources d'énergie. L'invention porte également sur un inverseur de sources comportant des moyens pour la mise en œuvre d'un tel procédé.

### ETAT DE LA TECHNIQUE

La disponibilité de l'énergie électrique est importante, entre autres pour les hôpitaux, pour les industries de production en continu ou pour les installations fonctionnant avec de gros moyens informatiques. En effet, une coupure intempestive de l'alimentation en énergie électrique peut être à l'origine de dysfonctionnement des équipements alimentés. En conséquence, pour éviter une coupure intempestive de l'alimentation électrique, un dispositif appelé généralement inverseur de sources est utilisé : dès que la source principale d'énergie n'est plus disponible, l'inverseur de sources commute automatiquement l'arrivée de l'énergie électrique sur une seconde source d'énergie disponible. Cette seconde source est généralement un groupe électrogène mais peut être une ligne électrique différente ou une sortie d'un transformateur redondant de l'installation électrique. Par ailleurs, il est de plus en plus fréquent de disposer de plusieurs autres sources d'énergie afin de pallier toute défaillance de la seconde source, par exemple un non démarrage du groupe électrogène ou des opérations de maintenance de ligne électrique. La seconde source fournit l'énergie tant que la source principale est indisponible. Quand celle-ci redevient disponible, en règle générale, l'inverseur de sources déconnecte la seconde source pour reconnecter automatiquement l'utilisateur sur la source principale. Selon le besoin de l'utilisateur, d'autres modes de transition vers un retour à une situation normale peuvent exister.

La sûreté de fonctionnement et la sécurité des biens et/ou des personnes étant en jeu, le fonctionnement de l'inverseur de sources doit être fiable et sans dysfonctionnement. La complexité de l'installation et le risque de dysfonctionnement s'accroissent de manière exponentielle quand l'installation comporte plus de deux sources et lorsque la puissance de l'installation électrique dépasse plusieurs centaines d'ampères : les commutateurs utilisés peuvent être des disjoncteurs de puissance assurant la fonction complémentaire de protection contre les courts-circuits. Ces disjoncteurs de puissance ont un fonctionnement plus complexe que de simples contacteurs, en particulier leur manœuvre nécessite une étape de réarmement entre l'ouverture et la fermeture, ils peuvent être embrochés ou débrochés pour des opérations de maintenance. En cas de problème, il est indispensable d'apporter un maximum d'informations et d'assistance à l'exploitant afin de l'aider à résoudre rapidement le problème. En effet, un arrêt d'exploitation peut être à l'origine de perte économique ou humaine importante.

Le document EP 2 903 129 A1 décrit le fonctionnement d'un inverseur de sources destiné à la gestion de deux sources pouvant être de type réseau de distribution d'énergie ou générateur de secours selon cinq modes de fonctionnement différents. Ce dispositif est optimisé pour deux sources mais ne permet pas facilement l'intégration d'autres sources d'énergie.

Le document US 2004/169422 décrit le fonctionnement d'un inverseur de sources destiné à la gestion de trois sources d'énergie construit à partir de deux inverseurs de sources fonctionnant en cascade, chacun des deux inverseurs de sources ne gérant que deux sources. Cette disposition est bien adaptée pour une utilisation domestique ou petit tertiaire compte tenu du coût raisonnable de chacun des inverseurs de source mais ne correspond pas à une solution économiquement intéressante dans un milieu ou l'énergie mise en jeu est importante. D'autre part, le nombre de modes de fonctionnement est limité par le principe de mise en cascade, la priorité des sources étant fixée par la position des entrées des sources sur les inverseurs.

Le document US 2004/124710 concerne un dispositif particulier d'alimentation d'une charge principale par un générateur de secours au travers d'un interrupteur spécifique. Cet interrupteur spécifique fonctionne parallèlement à un inverseur de source pour continuer à alimenter la charge principale après le retour de la tension réseau afin de ne pas générer de perturbations.

L'invention a pour objet un procédé de contrôle d'un inverseur de sources permettant de s'adapter à une grande variété de configurations d'installations électriques et de types de commutateurs tout en assurant une grande sécurité de fonctionnement. En cas de défaut de fonctionnement de l'inverseur de sources, le procédé de contrôle selon l'invention apporte une aide au diagnostic ce qui permet de réduire la durée de la panne et par conséquent minimiser toute perte éventuelle engendrée par un arrêt de fonctionnement.

### EXPOSE DE L'INVENTION

Pour cela, l'invention décrit un procédé de contrôle d'un inverseur de sources d'énergie électrique conforme à la revendication 1I, ledit inverseur comportant :
- des entrées pour recevoir des états de disponibilité de plusieurs sources d'énergie,
- des entrées pour recevoir des modes de fonctionnement possibles de l'inverseur de sources, et
- des sorties pour commander un état ouvert ou fermé de commutateurs destinés à connecter les sources d'énergie électrique à une ou plusieurs charges,
le procédé comportant :
- une étape d'identification de toutes les combinaisons des modes de fonctionnement possibles et des états de disponibilité possibles des sources d'énergie, et
- une étape d'association consistant à associer une configuration d'état ouvert ou fermé de chaque commutateur à chaque combinaison identifiée à l'étape d'identification.

Avantageusement, le procédé de contrôle comporte en outre une étape :
- de lecture d'un mode de fonctionnement opérationnel choisi parmi les modes de fonctionnement possibles, et
- de lecture des états de disponibilité des sources d'énergie.

Avantageusement, le procédé de contrôle d'un inverseur de sources comporte en outre une étape de surveillance d'un changement de mode de fonctionnement opérationnel ou d'un changement d'état de disponibilité d'une ou plusieurs sources d'énergie.

Préférentiellement, dans le cas d'un changement de mode de fonctionnement opérationnel ou d'un changement d'état de disponibilité d'une ou plusieurs sources d'énergie, le procédé effectue une étape de commande des sorties pour mettre les commutateurs dans la configuration associée à la nouvelle combinaison du mode de fonctionnement opérationnel et de l'état des sources d'énergie.

Avantageusement, l'inverseur de sources comportant en outre des entrées pour recevoir des états réels des commutateurs, et, en l'absence de changement de mode de fonctionnement opérationnel et en l'absence de changement d'état de disponibilité d'une ou plusieurs sources d'énergie, le procédé comporte une étape de contrôle de conformité, destinée à contrôler la conformité entre la configuration d'état ouvert ou fermé de chaque commutateur et l'état réel desdits commutateurs.

Préférentiellement, dans le cas d'une non-conformité entre la configuration d'état de chaque commutateur et l'état réel desdits commutateurs, alors ledit procédé comporte une étape supplémentaire d'information et de demande de validation par l'opérateur pour retourner à l'étape de commande des sorties. Avantageusement, l'inverseur de sources comportant en outre des entrées pour recevoir des états de défaut, le procédé comporte une étape de détection de présence d'au moins un état de défaut.

Préférentiellement, dans le cas de la présence d'au moins un état de défaut, le procédé comporte une étape d'aide à l'opérateur pour le diagnostic du défaut.

Avantageusement, l'étape d'aide à l'opérateur pour le diagnostic du défaut consiste à mettre à disposition de l'opérateur au moins les informations de l'état des sources d'énergie, du mode de fonctionnement opérationnel, de l'état réel des commutateurs, et du ou des états de défaut.

Préférentiellement, l'étape d'aide au diagnostic est exécutée tant qu'un état de défaut est présent.

Avantageusement, l'étape de contrôle de conformité est exécutée quand tous les états de défaut ont disparu.

Avantageusement, le procédé de contrôle d'un inverseur de sources est mis en œuvre dans un dispositif de test comportant :
- des connexions pour recevoir des signaux simulant des états de disponibilité des sources d'énergie,
- des connexions pour recevoir des signaux simulant des états des commutateurs,
- des connexions pour recevoir des signaux simulant des états de défaut,
- des connexions pour émettre des signaux vers des sorties simulant une commande des commutateurs destinés à connecter des sources d'énergie électrique à la ou les charges,
- une interface opérateur destinée à afficher des messages et sélectionner un mode de fonctionnement opérationnel parmi plusieurs modes de fonctionnement possibles, et
- une unité de traitement de données comportant :
   - un ou plusieurs circuits pour actionner l'interface opérateur,
   - un ou plusieurs circuits pour faire l'acquisition des signaux simulant les états des commutateurs,
   - un ou plusieurs circuits pour faire l'acquisition des signaux simulant les états de disponibilité des sources d'énergie,
   - un ou plusieurs circuits pour faire l'acquisition des signaux simulant les états de défaut,
   - un ou plusieurs circuits pour exécuter les étapes du procédé, et
   - un ou plusieurs circuits pour émettre des signaux pour activer des sorties de commande.

Préférentiellement, le procédé de contrôle d'un inverseur de sources mis en œuvre dans le dispositif de test est tel que :
- les signaux simulant des états de disponibilité des sources d'énergie, les signaux simulant des états des commutateurs et les signaux simulant des états de défaut sont fournis par des moyens électriques ou informatiques activés par un opérateur, et
- les signaux vers des sorties simulant une commande des commutateurs activent un dispositif d'affichage d'état,

Avantageusement, le procédé de contrôle d'un inverseur de sources mis en œuvre dans le dispositif de test est tel que les signaux simulant le mode de fonctionnement, les états de disponibilité des sources d'énergie, les signaux simulant des états des commutateurs et les signaux simulant des états de défaut sont fournis selon des scénarios préenregistrés ou générés au moyen de fonctions aléatoires.

Préférentiellement, le procédé de contrôle d'un inverseur de sources mis en œuvre dans le dispositif de test est tel que les signaux simulant les états et les signaux vers les sorties sont représentés de manière graphique sur l'interface opérateur.

L'invention a également pour objet un inverseur de sources pour la mise en œuvre du procédé décrit précédemment, l'inverseur de sources comportant :
- des entrées pour recevoir des états de disponibilité des sources d'énergie,
- des entrées pour recevoir des états réels des commutateurs,
- des entrées pour recevoir des états de défaut,
- des sorties pour commander les commutateurs destinés à connecter des sources d'énergie électrique à la ou les charges,
- une interface opérateur destinée à afficher des messages et sélectionner un mode de fonctionnement opérationnel parmi plusieurs modes de fonctionnement possibles, et
- une unité de traitement de données comportant :
   - un ou plusieurs circuits pour actionner l'interface opérateur,
   - un ou plusieurs circuits pour faire l'acquisition des états réel des commutateurs,
   - un ou plusieurs circuits pour faire l'acquisition des états de disponibilité des sources d'énergie,
   - un ou plusieurs circuits pour faire l'acquisition des états de défaut,
   - un ou plusieurs circuits pour exécuter les étapes du procédé, et
   - un ou plusieurs circuits pour activer les sorties de commande.

### BREVE DESCRIPTION DES DESSINS

D'autres avantages et caractéristiques ressortiront plus clairement de la description qui va suivre, de modes particuliers de réalisation de l'invention, donnés à titre d'exemples non limitatifs, et représentés aux dessins annexés sur lesquels :
- la figure 1 est une représentation schématique conventionnelle d'une installation électrique comportant un inverseur de sources,
- la figure 2 est une représentation schématique des configurations possibles d'états ouvert ou fermé de commutateurs commandés par un inverseur de sources opérant avec deux sources d'énergie,
- la figure 3 est un diagramme d'état représentant différents états de fonctionnement d'un inverseur de sources et les conditions de passage d'un état de fonctionnement donné vers un autre état,
- la figure 4 est un synoptique d'un inverseur de sources montrant une interface vers un opérateur pour recevoir des informations ou choisir un mode de fonctionnement, des entrées d'information de capteurs d'état et des entréessorties vers des commutateurs destinés à connecter des sources d'énergie électrique à des charges selon le procédé de l'invention,
- la figure 5 est une table d'identification de toutes les combinaisons possibles pour quatre modes de fonctionnement demandés par l'opérateur et deux états possibles de disponibilité de deux sources d'énergie avec une configuration d'état des commutateurs correspondant à chaque combinaison,
- la figure 6 est un organigramme illustrant le fonctionnement d'un procédé de contrôle d'un inverseur de sources selon l'invention,
- la figure 7 est une représentation schématique d'un inverseur de sources permettant la mise en œuvre du procédé de contrôle selon l'invention, et
- la figure 8 est une représentation schématique d'une installation électrique comportant plus de deux sources d'énergie électrique et plus de deux commutateurs.

### DESCRIPTION DETAILLEE DE MODES DE REALISATION PREFERES

Dans la description, l'expression « une source est disponible » sera utilisée pour qualifier une source en capacité de délivrer de l'énergie électrique.

Le terme « commutateur » sera utilisé pour dénommer préférentiellement un disjoncteur électrique mais peut aussi dénommer un contacteur, un interrupteur, une des voies d'un contacteur double, un relais ou encore un interrupteur électronique statique à semi-conducteurs. Un commutateur « ouvert » est un commutateur ne laissant pas passer l'énergie, un commutateur « fermé » laisse passer l'énergie.

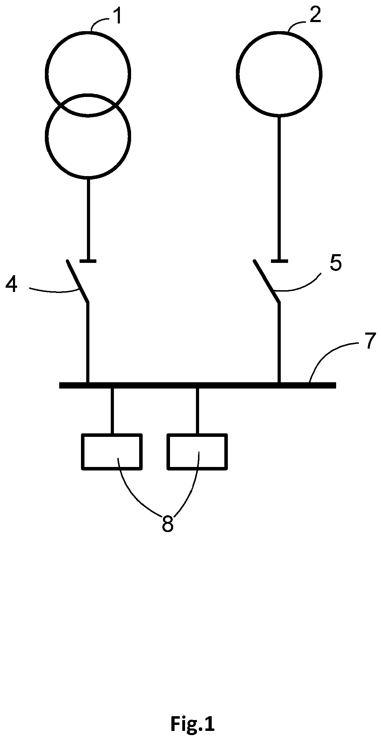

La figure 1 est une représentation schématique conventionnelle d'une installation électrique comportant un inverseur de sources. Une source 1, généralement une source dite « principale », fournit l'énergie électrique à une ou plusieurs charges 8. Une charge 8 peut être un équipement ou un ensemble de plusieurs équipements dont le fonctionnement ne doit pas être interrompu, comme, par exemple, une zone technique contenant des équipements devant être alimentés en permanence ou un bâtiment dont l'alimentation en énergie présente un aspect critique. Dans la suite du document, le terme « charge » pourra couvrir une charge ou plusieurs charges. Un commutateur 4, connecté en amont à la source 1 et en aval à un jeu de barre 7, établit une liaison électrique entre la source 1 et le jeu de barre 7. La charge 8 est connectée au jeu de barre 7.

En cas d'indisponibilité de la source principale 1, par exemple suite à une ouverture du circuit amont de l'installation, l'inverseur de sources a pour rôle de commander le commutateur 5, connecté, en amont, à une seconde source d'énergie électrique 2 et, en aval, au jeu de barre 7, afin de mettre en liaison électrique la seconde source 2 avec la charge 8 et permettre ainsi de continuer à alimenter la charge 8. La seconde source 2 est généralement une source de secours et pourra être un générateur local tel qu'un groupe électrogène. Par mesure de sécurité, le commutateur 4 sera ouvert. Quand la source principale 1 est à nouveau disponible, l'inverseur de sources commande la fermeture du commutateur 4 et l'ouverture du commutateur 5 afin de revenir à la situation d'origine.

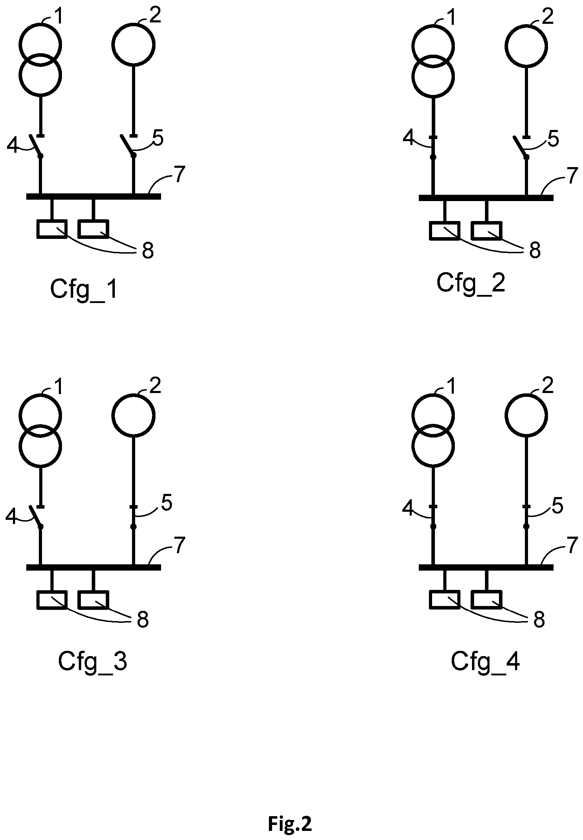

La figure 2 est une représentation schématique des configurations possibles d'états ouvert ou fermé des commutateurs 4 et 5 dans le cas d'un inverseur de sources opérant avec deux sources d'énergie 1 et 2. Chacun des commutateurs 4, 5 peut prendre deux positions : une position fermée ou une position ouverte. Quatre combinaisons sont donc possibles :
- une première configuration dénommée Cfg_1 dans laquelle les deux commutateurs 4 et 5 sont ouverts, c'est-à-dire non passants. La charge 8 n'est pas alimentée,
- une deuxième configuration dénommée Cfg_2 dans laquelle le commutateur 4 est fermé, c'est-à-dire passant, et le commutateur 5 est ouvert. La charge 8 est alimentée par la source principale 1,
- une troisième configuration dénommée Cfg_3 dans laquelle le commutateur 4 est ouvert et le commutateur 5 est fermé. La charge 8 est alimentée par la seconde source 2, et
- une quatrième configuration dénommée Cfg_4 dans laquelle les deux commutateurs 4, 5 sont fermés. La charge 8 est alimentée par les deux sources 1 et 2. Lesdites sources doivent être en phase pour un fonctionnement permanent sinon cette configuration Cfg_4 doit être interdite.

Le rôle principal de l'inverseur de sources est de gérer automatiquement la fermeture et l'ouverture des commutateurs 4, 5 en fonction de la disponibilité des sources 1, 2 afin que la charge soit alimentée en dépit des aléas de disponibilité des sources 1, 2. Les configurations Cfg_2 et Cfg_3 répondent à ce besoin. Cependant, un opérateur peut décider d'effectuer une intervention au niveau de la charge 8 et commander un arrêt d'alimentation de la charge 8. La configuration Cfg_1 répond à ce besoin. Enfin, la configuration Cfg_4 peut être utilisée pour fournir un maximum d'énergie à la charge 8. L'inverseur de sources a donc pour fonction de commander les commutateurs 4 et 5 en fonction des demandes de l'opérateur et en fonction de la disponibilité des sources 1 et 2. L'inverseur de sources est donc un système agissant en fonction des informations issues de son environnement.

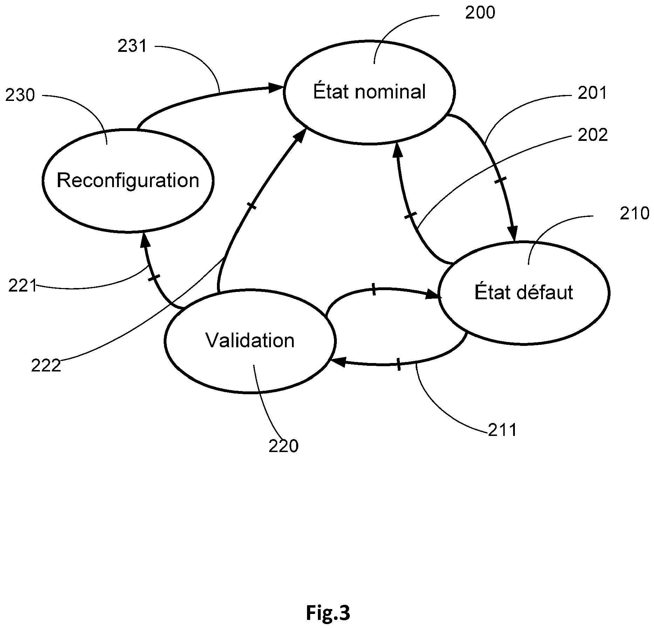

Le procédé de contrôle de l'inverseur de sources est représenté en figure 3 sous forme d'un diagramme d'état. L'inverseur de sources peut être dans un état nominal 200. Dans ce mode, la configuration en cours correspond à une configuration attendue, ladite configuration attendue étant fonction d'un mode de fonctionnement choisi par l'opérateur et de la disponibilité des sources. Quand il y a un écart entre la configuration en cours et la configuration attendue, le système passe dans un état en défaut 210 par une transition 201. L'écart peut être justifié, par exemple, par une panne dans l'appareillage ou par une alarme issue d'un des équipements, par exemple un échauffement excessif de la source 2, ou encore par une surintensité ayant amené l'ouverture d'un des commutateurs. Dans ce cas, une intervention de l'opérateur est nécessaire pour réparer le défaut. Quand le défaut est éliminé, si la configuration en cours correspond à la configuration attendue, le système retourne automatiquement, c'est-à-dire sans intervention complémentaire de l'opérateur, vers l'état de fonctionnement nominal 200 par une transition 202. Quand, l'écart est lié à un changement de configuration d'origine externe à l'inverseur de sources, par exemple l'ouverture manuelle d'un commutateur par l'opérateur, le système passe par une transition 211 dans un mode d'attente 220 en affichant un message à destination de l'opérateur pour l'inviter à valider un retour vers l'état de fonctionnement nominal, c'est-à-dire un retour vers une configuration du système conforme à la configuration attendue en passant par une transition 221. Le message sera, par exemple, « Valider pour retourner au fonctionnement nominal » ou « Press OK to resume » en anglais. Ce mode de fonctionnement permet à l'opérateur de valider la fin de son intervention, dans le cas où, par exemple, ledit opérateur a ouvert manuellement un commutateur. L'inverseur de sources procédera alors à une reconfiguration 230, ce qui correspond, dans cet exemple, à la fermeture du commutateur ouvert précédemment par l'opérateur, et un retour vers l'état de fonctionnement nominal 200 par une transition 231. Quand, une reconfiguration n'est pas nécessaire parce que la configuration en cours correspond à la configuration attendue, après l'étape de validation 220 le système retourne à l'état de fonctionnement nominal 200 par la transition 222.

Le procédé de contrôle de l'invention est construit sur la base du diagramme représenté sur la figure 3. Il est applicable quel que soit le nombre de sources, le nombre de commutateurs ou encore quel que soit le câblage entre les sources et les commutateurs. Quand il est en état de fonctionnement nominal 200, l'inverseur de sources peut fonctionner selon différents modes :
- un premier mode Md1 appelé « mode automatique » dans lequel l'inverseur de sources bascule automatiquement dans la configuration Cfg_3 quand la source 1 n'est plus disponible et bascule automatiquement dans la configuration Cfg_2 quand la source 1 est à nouveau disponible,
- un deuxième mode Md2 appelé « mode secours forcé » dans lequel l'inverseur de sources bascule dans la configuration Cfg_3 et reste dans cette configuration indépendamment de la disponibilité des sources 1 et 2. Ce mode peut être utilisé par exemple pour délester la source 1,
- un troisième mode Md3 appelé « mode maintenance » dans lequel l'inverseur de sources bascule dans la configuration Cfg_1 et reste dans cette configuration indépendamment de la disponibilité des sources 1 et 2. Ce mode peut être utilisé par exemple pour effectuer des opérations de maintenance sur la charge 8, et
- un quatrième mode Md4 appelé « mode couplage » dans lequel l'inverseur de sources bascule dans la configuration Cfg_4 c'est-à-dire avec la charge 8 connectée simultanément aux sources 1 et 2.

D'autres modes de fonctionnement peuvent être envisagés en fonction du besoin de l'opérateur ou de la configuration de l'installation électrique. L'utilisateur choisit parmi ces différents modes et en fonction de son besoin, un mode qui sera dénommé par la suite « mode de fonctionnement opérationnel ».

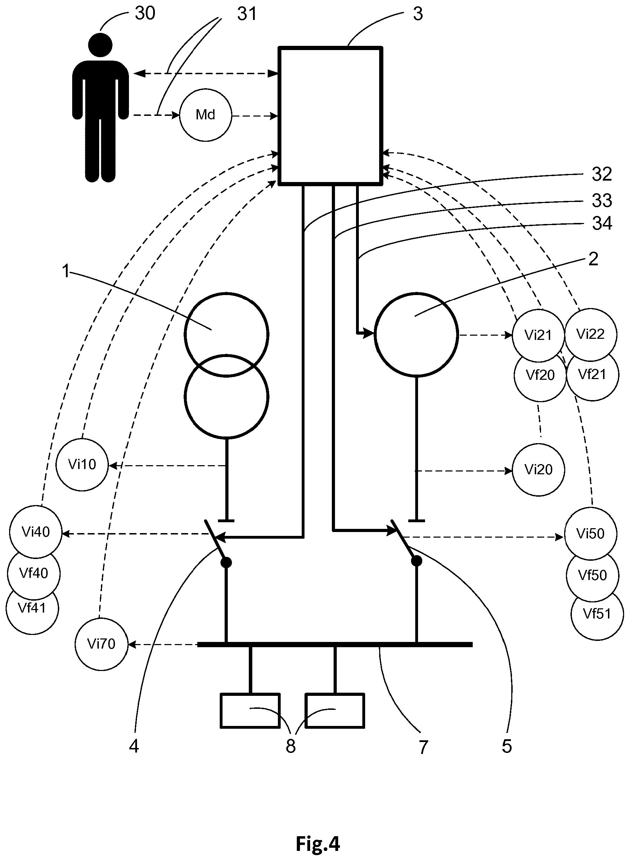

Pour gérer la fermeture et l'ouverture des commutateurs 4, 5 en fonction de la disponibilité des sources 1 et 2, l'inverseur de sources 3 a besoin de recevoir des informations sur la disponibilité des sources 1 et 2, sur l'état ouvert ou fermé des commutateurs 4 et 5 et sur le mode de fonctionnement opérationnel désiré par l'opérateur. La figure 4 représente un synoptique de l'inverseur de sources montrant :
- une interface 31 vers l'opérateur 30,
- des entrées d'information d'état Vi ou de défaut Vf, et
- des sorties 32, 33 vers des commutateurs 4 et 5.

L'opérateur 30 est informé du fonctionnement de l'inverseur de sources par une interface 31 locale et/ou distante. Cette interface comporte par exemple un écran pour afficher des messages, des voyants et un clavier ou des boutons permettant une saisie de donnée ou une validation d'une opération ou encore sélectionner un mode de fonctionnement opérationnel Md parmi plusieurs modes de fonctionnement possibles Md1 à Md4. L'inverseur de sources 3 reçoit des informations sur la disponibilité des sources: Vi10 est une variable d'entrée donnant l'état de disponibilité de la source 1. Vi10 peut être une donnée binaire, par exemple Vi10 = 0 quand la source principale 1 n'est pas disponible et Vi10 = 1 quand la source principale 1 est disponible. Vi10 peut aussi être une donnée numérique, par exemple une valeur de tension de la source 1 (Vi10 = 380 Volt) ou encore une donnée en format texte, par exemple Vi10 = « présent » ou Vi10 = « absent ». De la même façon, la variable Vi20 informe l'inverseur de sources 3 de l'état de disponibilité de la source 2, la variable Vi70 informe l'inverseur de sources 3 de la présence de tension sur le jeu de barre 7. D'autres variables peuvent être utiles au fonctionnement de l'inverseur de sources. Par exemple une variable Vi21 peut représenter le niveau de carburant destiné à un moteur thermique couplé à une génératrice d'énergie électrique formant la seconde source 2. Dans ce cas, une variable Vi22 peut représenter la vitesse de rotation de ladite génératrice d'énergie électrique.

L'inverseur de sources 3 reçoit des informations sur l'état réel des commutateurs 4 et 5. Vi40 est l'état réel du commutateur 4. Vi40 peut être une donnée binaire, par exemple Vi40 = 0 quand le commutateur 4 est ouvert et Vi40 = 1 quand le commutateur 4 est fermé. Vi40 peut aussi être une donnée en format texte, par exemple Vi40 = « ouvert » ou Vi40 = « fermé ». De la même façon, Vi50 informe l'inverseur de sources 3 sur l'état réel du commutateur 5. L'ensemble de ces variables sera appelé par la suite « variables d'entrée ».

L'inverseur de sources 3 dispose de sorties pour commander le basculement des commutateurs 4 et 5. Une sortie 32 permet d'activer l'ouverture ou la fermeture du commutateur 4. Une sortie 33 permet d'activer l'ouverture ou la fermeture du commutateur 5. Les sorties 32 et 33 permettent ainsi de changer la configuration des commutateurs. Dans certains types d'inverseur de sources, une sortie 34 commande un démarrage ou un arrêt d'un moteur thermique destiné à entraîner une génératrice d'énergie électrique formant la seconde source 2.

Des variables complémentaires sont utilisées par l'inverseur de sources pour informer l'opérateur de tout défaut de fonctionnement. Ces variables appelées par la suite « variables de défaut » sont, par exemple, Vf40 pour indiquer que le commutateur 4 s'est ouvert automatiquement à cause d'une surintensité, Vf41 pour indiquer un commutateur 4 en position débroché. De même façon, Vf50 indique que le commutateur 5 s'est ouvert automatiquement à cause d'une surintensité, Vf51 indique un commutateur 5 en position débroché. La variable Vf20, par exemple, indique l'état de la batterie de démarrage du moteur thermique, la variable Vf21 indique la température de la génératrice d'énergie électrique formant la seconde source 2.

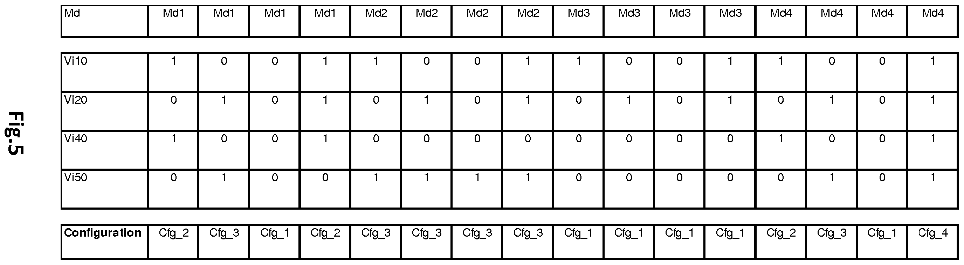

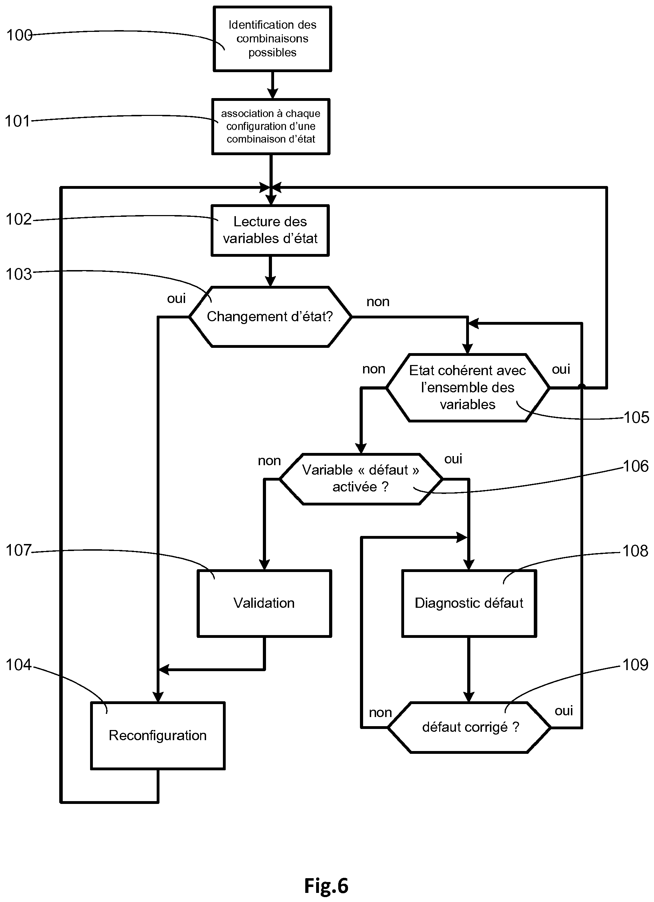

La figure 6 est un organigramme illustrant le fonctionnement d'un procédé de contrôle d'un inverseur de sources selon l'invention. Une première étape 100 du procédé de contrôle de l'inverseur de sources consiste à identifier toutes les combinaisons possibles des modes de fonctionnement et des états de disponibilité des sources d'énergie. Par exemple, pour quatre modes Md1 à Md4 et deux sources pouvant être soit disponibles, soit indisponibles, il existe seize combinaisons différentes possibles (quatre modes multiplié par deux sources multiplié par deux états possibles de chacune des sources). Le nombre de combinaisons ne dépend que du nombre de sources d'énergie et du nombre de modes de fonctionnement. Ces combinaisons sont rassemblées dans un tableau en figure 5.

Une seconde étape 101 du procédé consiste à associer une configuration unique d'état ouvert ou fermé de chaque commutateur à chaque combinaison identifiée à l'étape 100. A titre d'exemple, le tableau en figure 5 indique l'ensemble des combinaisons possibles dans le cas de quatre modes de fonctionnement (MD1 étant un « mode automatique », Md2 étant un « mode secours forcé », Md3 étant un « mode maintenance », MD4 étant un « mode couplage ») et pour chaque état possible des sources (Vi10 et Vi20 donnant respectivement l'état de disponibilité des sources 1 et 2 sous forme binaire). Ainsi en « mode automatique » MD1, quand la source 1 est présente (Vi10 = 1) et quand la source 2 est absente (Vi20 = 0), la configuration Cfg_2 doit être réalisée, ce qui correspond au commutateur 4 dans un état fermé et le commutateur 5 en état ouvert. Si la source 1 devient indisponible (Vi10 = 0) et que la source 2 est indisponible elle aussi (Vi20 = 0), l'inverseur doit être dans la configuration Cfg_1, ce qui correspond au commutateur 4 et au commutateur 5 en état ouvert. La construction du tableau est réalisée au moment de la conception de l'installation électrique puis le tableau est implanté de préférence dans une mémoire 42 dans l'inverseur de sources afin que celui-ci puisse actionner les commutateurs 4 et 5 en fonction de la configuration souhaitée. L'association de chaque combinaison identifiée à l'étape 100 avec une configuration unique des commutateurs peut être réalisée au moyen d'un tableau comme dans l'exemple précédent ou au moyen d'une équation ou tout autre moyen de calcul ou de modélisation.

Comme indiqué en figure 6, au cours d'une étape 102, il y a scrutation de l'ensemble des variables d'entrée. Cette scrutation consiste en une lecture d'un mode de fonctionnement opérationnel Md choisi par l'opérateur parmi les modes de fonctionnement possibles Md1 à Md4, ce choix étant effectué au moyen de l'interface opérateur 31, et une lecture des états de disponibilité Vi10, Vi20 des sources d'énergie 1, 2. Au cours d'une étape 103 il y a détection de tout changement de mode de fonctionnement opérationnel Md ou changement de disponibilité d'une ou plusieurs sources 1, 2. Dès qu'un changement est détecté, l'étape 104 met les commutateurs 4 et 5 dans la configuration associée à la nouvelle combinaison du mode de fonctionnement opérationnel Md et de l'état des sources d'énergie, conformément au tableau de la figure 5, puis il y a retour à l'étape 102.

S'il n'y a pas de changement de configuration au cours de l'étape 103, une étape 105 contrôle la conformité de l'ensemble des variables d'entrée par rapport à la configuration en cours. Si toutes les variables d'entrée sont conformes avec la configuration, il y a retour à l'étape 102. L'étape 105 est donc exécutée cycliquement, tant que toutes les variables d'entrée sont conformes avec la configuration. Si au moins une variable d'entrée n'est pas conforme avec la configuration, une étape de test 106 détecte si une variable défaut est activée. Dans ce cas, à l'étape 108, une identification de la variable de défaut activée est communiquée à l'opérateur au moyen de l'interface 31, accompagnée de toute autre information utile afin que l'opérateur puisse faire rapidement le diagnostic du problème à l'origine de l'activation de la variable défaut. En complément, l'utilisation d'une base de données de diagnostic élaborée par des experts peut être implantée dans l'inverseur pour guider l'opérateur dans sa démarche. Une étape 109 vérifie que l'opérateur a corrigé le défaut en recherchant toute variable défaut active. S'il reste une variable défaut active, il y a retour à l'étape 108 avec mise à jour éventuelle des informations destinées à l'opérateur. Quand il ne reste aucune variable défaut active à l'étape 109, il y a retour à l'étape 105 pour la vérification de conformité de l'ensemble des variables d'entrée par rapport à la configuration en cours. Si au moins une variable d'entrée n'est pas conforme avec la configuration à l'étape 105 mais qu'il n'y a pas de variable défaut active, il y a passage à l'étape 107 correspondant à une validation de la part de l'opérateur. Dans cette étape, un message indiquant une non-conformité sera affiché au moyen de l'interface 31 puis une invitation à revenir à une situation normale sera émise au moyen d'un message tel que, par exemple, « Valider pour retourner au fonctionnement nominal » ou « press OK to resume » en anglais. Après validation par l'opérateur à l'étape 107, il y a retour à l'étape 104 pour reconfigurer les commutateurs afin de les mettre dans un état conforme à la configuration souhaitée.

Pour illustrer cette phase du procédé, il peut advenir que, par exemple, à l'étape 105, la variable d'entrée Vi50 donnant l'information sur l'état du commutateur 5 n'est pas conforme avec l'état demandé par la configuration suite à une intervention de l'opérateur ayant commandé manuellement le commutateur 5. En l'absence de variable de défaut active testée à l'étape 106, il y a passage à l'étape 107. Une signalisation de la non-conformité de la variable Vi50 est émise à destination de l'opérateur au moyen de l'interface 31 et une invitation à valider une remise en conformité lui est proposée. Après validation de l'opérateur, il y a passage à l'étape 104 de reconfiguration des commutateurs. Dans cet exemple, une commande du commutateur 5 sera effectuée pour le remettre dans l'état demandé par la configuration.

Le procédé de l'invention permet ainsi de contrôler un inverseur de sources en limitant les risques de mauvaise manœuvre de l'inverseur. En effet, toutes les combinaisons possibles de modes de fonctionnement et d'états de disponibilité des sources d'énergie sont prises en compte et une combinaison unique d'état des commutateurs est associée à chaque combinaison. Il n'y peut donc y avoir aucun état indéterminé. En cas de défaillance d'un composant ou après une opération manuelle, le procédé permet de retourner au fonctionnement nominal en apportant les informations nécessaires puis en exécutant les actions nécessaires sur les commutateurs après validation par l'opérateur. Ce mode de fonctionnement est particulièrement avantageux parce qu'il évite une activation automatique des commutateurs pour les remettre dans l'état attendu alors que l'opérateur est en cours d'intervention sur l'installation électrique. D'autre part, l'opérateur intervient principalement via l'interface 31 ce qui évite une intervention directe sur l'appareillage ainsi qu'un risque d'erreur de manœuvre de l'appareillage. Les informations étant centralisées vers l'opérateur, il dispose de toutes les données nécessaires pour prendre rapidement les bonnes décisions. Une remise en marche rapide après un arrêt d'alimentation électrique permet, par exemple, de limiter la perte économique liée à un arrêt de production.

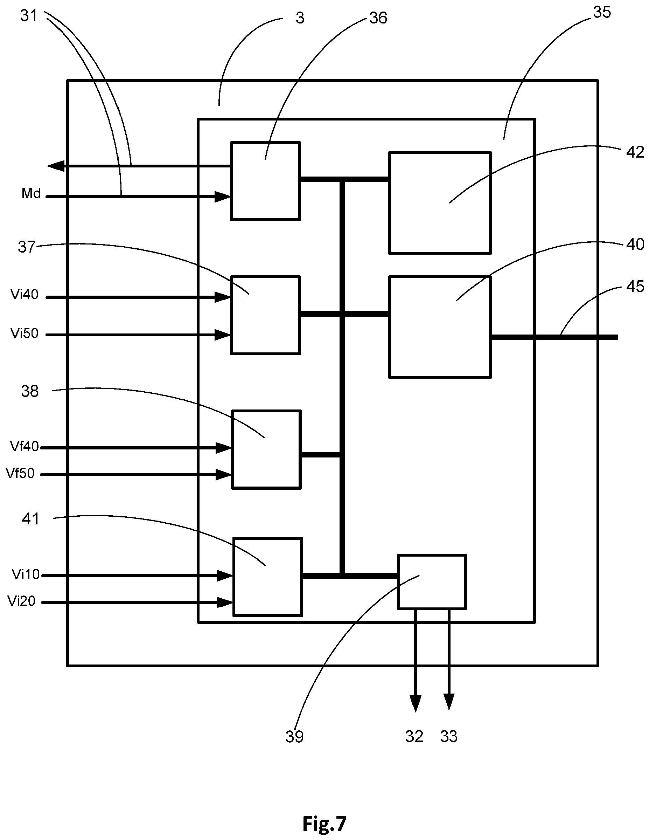

Le procédé de l'invention est préférentiellement destiné à être mis en œuvre dans un inverseur de sources 3. La figure 7 est une représentation schématique d'un tel inverseur de sources. L'inverseur de sources est composé d'un ou plusieurs boitiers comportant :
- des entrées pour recevoir des états de disponibilité Vi10, Vi20 des sources d'énergie,
- des entrées pour recevoir des états réels Vi40, Vi50 des commutateurs 4, 5,
- des entrées pour recevoir des états de défaut Vf,
- des sorties 32, 33 pour commander des commutateurs 4, 5 destinés à connecter des sources d'énergie électrique 1,2 à des charges 8,
- une interface opérateur 31 destinée à afficher des messages, des informations de diagnostic et sélectionner un mode de fonctionnement opérationnel Md parmi plusieurs modes de fonctionnement possibles Md1 à Md4, et
- une unité de traitement de données 35 comportant un ou plusieurs circuits 36 pour actionner l'interface opérateur 31, un ou plusieurs circuits 37 pour faire l'acquisition des entrées d'état réel Vi40, Vi50 des commutateurs 4 et 5, un ou plusieurs circuits 38 pour faire l'acquisition des états de défaut Vf, un ou plusieurs circuits 41 pour faire l'acquisition des états de disponibilité Vi10, Vi20 des sources d'énergie, un ou plusieurs circuits 39 pour activer les sorties de commande 32, 33 et un ou plusieurs circuits 40 pour exécuter les étapes du procédé.

Le ou les circuits 40 sont préférentiellement un ou plusieurs microprocesseurs. Une ou plusieurs mémoires 42 sont utilisées pour mémoriser les étapes du procédé, les données représentées dans le tableau en figure 5 ainsi que les données utiles au diagnostic et à l'exécution du procédé. Les données sont transférées dans la ou les mémoires 42 directement ou via le circuit 40, comme représenté sur la figure 7, par tout moyen de transmission de données 45 connu de la technique, par exemple une connexion à un réseau de communication, un port USB, une connexion sans fil Wifi ou NFC selon un protocole de communication adapté. La possibilité de mise à jour des données représentées dans le tableau en figure 5 ou des données de diagnostic est particulièrement utile en milieu industriel. En effet, l'installation électrique étant régulièrement adaptée à l'évolution de l'activité, une modification de mode de fonctionnement ou du nombre de sources d'énergie ne nécessite pas de gros efforts de programmation ni de longue validation des modifications.

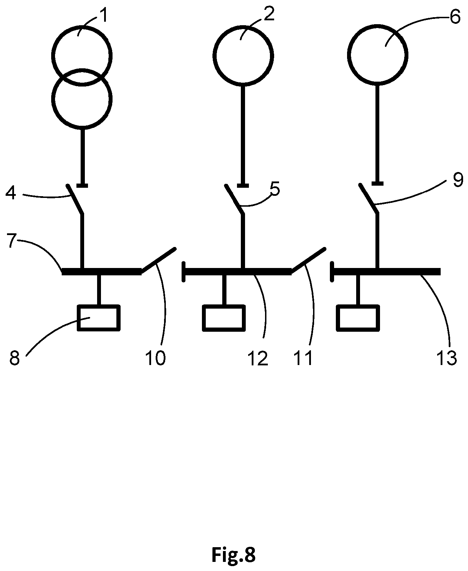

La présente invention n'est nullement limitée aux modes de réalisation décrits. Par exemple, le procédé peut être appliqué à une installation électrique comportant plus de deux sources 1, 2, 6 et plus de deux commutateurs 4, 5, 9, 10, 11 telle que représentée en figure 8. En particulier, le dispositif peut s'appliquer à une installation électrique comportant des commutateurs 10, 11 ayant pour fonction de coupler des jeux de barre 7, 12, 13. Le nombre de combinaisons possibles reste toujours dénombrable : dans l'exemple illustré en figure 8, l'inverseur de sources peut fonctionner, par exemple, selon quatre modes de fonctionnement : un « mode automatique » Md5, un « mode secours» Md6 pendant lequel le générateur 2 est seul disponible et n'alimente qu'une partie du jeu de barre 12, le commutateur 5 étant fermé, un « mode maintenance » Md7 ou tous les commutateurs sont ouverts, un « mode délesté » Md8 pour lequel les sources 2 et 6 sont disponibles, les commutateurs 5, 9, 10, 11 sont fermés, le commutateur 4 est ouvert. Au cours de l'étape 100, sachant qu'il y a trois sources 1, 2 et 6, chaque source pouvant être disponible ou indisponible, le nombre de combinaisons possibles est évalué à vingt-quatre (quatre modes multiplié par trois sources multiplié par deux états possibles). Au cours de l'étape 101, une configuration d'état des commutateurs 4, 5, 9, 10 et 11 sera associée à chacune des vingt-quatre combinaisons. En théorie, 2⁵ soit 32 combinaisons sont possibles, correspondant à autant d'états différents des commutateurs 4, 5, 9, 10 et 11. Il existe donc, dans l'exemple illustré en figure 8, huit combinaisons non conformes avec l'ensemble des variables (trente-deux moins vingt-quatre). Dans le cas où, par exemple, pour effectuer une intervention, l'opérateur 30 place l'inverseur de sources en « mode maintenance » Md7 puis ferme le commutateur 11 pour tester le couplage des jeux de barre 12 et 13, l'étape 105 détecte la non-conformité de l'état des commutateurs par rapport à la variable mode Md7 et, en l'absence de variable de défaut active, l'étape 107 affichera une information signalant la non-conformité de l'état du commutateur 11 puis demande une validation de l'opérateur. A l'étape 104 le commutateur 11 est remis en position ouvert pour être en conformité avec la configuration correspondant au « mode maintenance » Md7.

Le procédé de l'invention est ainsi adapté à toute configuration d'installation électrique et permet de garantir un fonctionnement correct de l'inverseur de sources même quand les commutateurs se trouvent dans une configuration non identifiée à l'étape 100.

Le procédé de contrôle d'un inverseur de sources d'énergie électrique de l'invention est aussi destiné à être implanté dans un dispositif de test ou de simulation afin de simuler le fonctionnement d'un inverseur de sources. Le dispositif de test se présente de préférence sous forme d'un calculateur de type ordinateur ou automate programmable. Un tel dispositif de test est utilisé par des étudiants au cours de leur apprentissage ou dans le cadre de formation professionnelle d'utilisateurs, débutants ou confirmés. Le dispositif de test comporte :
- des connexions pour recevoir des signaux simulant des états de disponibilité (Vi20, Vi30) des sources d'énergie (1,2),
- des connexions pour recevoir des signaux simulant des états (Vi40, Vi50) des commutateurs (4, 5),
- des connexions pour recevoir des signaux simulant des états de défaut (Vf),
- des connexions pour émettre des signaux vers des sorties (32,33) simulant une commande des commutateurs (4, 5) destinés à connecter des sources d'énergie électrique à la ou les charges (8),
- une interface opérateur (31) destinée à afficher des messages et sélectionner un mode de fonctionnement opérationnel (Md) parmi plusieurs modes de fonctionnement possibles (Md1 à Md4), et
- une unité de traitement de données (35) comportant :
   - un ou plusieurs circuits (36) pour actionner l'interface opérateur (31),
   - un ou plusieurs circuits (37) pour faire l'acquisition des signaux simulant les états (Vi40, Vi50) des commutateurs (4, 5),
   - un ou plusieurs circuits (41) pour faire l'acquisition des signaux simulant les états de disponibilité (Vi20, Vi30) des sources d'énergie,
   - un ou plusieurs circuits (38) pour faire l'acquisition des signaux simulant les états de défaut (Vf),
   - un ou plusieurs circuits (40) pour exécuter les étapes du procédé, et
   - un ou plusieurs circuits (39) pour émettre des signaux pour activer des sorties de commande (32, 33).

Les signaux simulant des états de disponibilité (Vi20, Vi30) des sources d'énergie (1,2), les signaux simulant des états (Vi40, Vi50) des commutateurs (4, 5) et les signaux simulant des états de défaut (Vf) sont fournis par des moyens électriques comme des commutateurs, interrupteurs par exemple miniatures ou tout autre dispositif capable de fournir des signaux bas niveau ou encore par des signaux numériques pilotés par un automate ou un ordinateur externe. Les signaux vers des sorties (32,33) simulant une commande des commutateurs (4, 5) activent de préférence un dispositif d'affichage d'état, par exemple un panneau comportant des voyants ou encore un écran de type informatique. L'ensemble des données d'entrée, de sortie, les modes de fonctionnement sont, de préférence, représentés graphiquement sur une interface opérateur, telle qu'un écran d'ordinateur ou une projection d'image sur un écran mural.

Une mémoire du calculateur fait partie du ou des circuits pour exécuter les étapes du procédé (40). Cette mémoire contient une liste de toutes les étapes 100 à 109 du procédé ainsi que toutes les conditions de passage d'une étape à la suivante. Un programme informatique, exécuté par une unité de calcul faisant partie du ou des circuits (40) exécute le procédé de l'invention. L'état des variables d'entrée Vi10 à Vi70 et des variables de défaut Vf20 à Vf51 sont simulées au moyen de scénarios préenregistrés en mémoire ou générés de façon aléatoire. Par exemple, pour répondre au besoin d'apprentissage d'un utilisateur débutant, seuls des scénarios correspondant au changement de disponibilité des sources sont implantés. Pour répondre au besoin d'apprentissage d'un utilisateur expérimenté, des scénarios faisant intervenir des changements de disponibilité des source et l'apparition de défauts sont implantés. L'introduction dans un scénario d'apparition ou disparition aléatoire de défaut ou de disponibilité de source permet de tester la capacité de réaction de l'utilisateur à un événement imprévu. Une interface vers l'utilisateur, par exemple un écran et un clavier reliés au calculateur, permet la saisie de données en particulier pour l'identification des combinaisons possibles des modes Md de fonctionnement et des états des sources d'énergie selon l'étape 100 puis pour l'étape 101 d'association d'une configuration d'état des commutateurs pour chaque combinaison. Ensuite, le dispositif de test exécute le procédé de l'invention en utilisant l'état des variables d'entrée et de défaut faisant l'objet de scénarios et le mode de fonctionnement choisi. L'exécution des différentes étapes du procédé de contrôle est visualisée sur l'écran ainsi que l'état des liaisons 32, 33 et 34. Selon le niveau de compétence de l'utilisateur, plus ou moins de données peuvent être représentées ou affichées sur l'écran, des messages peuvent être affichés pour guider ou corriger les opérations de l'utilisateur. Le dispositif de test peut être implanté dans une valise transportable, une armoire de démonstration ou tout dispositif à usage pédagogique.

Un simulateur présente beaucoup d'intérêt pour la formation de l'utilisateur : celui-ci peut se familiariser avec l'utilisation de l'inverseur de sources tout en étant assuré de ne pas causer de dommages s'il fait une erreur. D'autre part, il est possible de réaliser la simulation d'une installation complexe, telle que celle représentée en figure 8, bien avant que ladite installation soit en fonctionnement. Un comportement non désiré peut être détecté et une correction effectuée avant la mise en exploitation. Un tel simulateur aura les avantages suivants :
- une validation des spécifications de fonctionnement de l'inverseur de sources dans lequel sera mis en œuvre le procédé pourra être mise en œuvre,
- le risque de dysfonctionnement sera réduit puisqu'un simulateur permet de tester tous les cas possibles, y compris des cas peu probables ou dangereux à réaliser dans une installation électrique réelle, et
- l'utilisateur sera plus confiant dans la manipulation de l'inverseur de sources parce qu'il disposera d'une très bonne maîtrise en phase d'utilisation et pourra réagir plus rapidement et plus efficacement. Le temps d'indisponibilité et les coûts d'arrêt de production seront minimisés.

## Revendications

1. Procédé de contrôle d'un inverseur de sources d'énergie électrique (3) pour alimenter une ou plusieurs charges (8), ledit inverseur comportant :
- des entrées pour recevoir des états de disponibilité (Vi10, Vi20) de plusieurs sources d'énergie (1, 2),
- des entrées pour recevoir des modes de fonctionnement possibles (Md1 à Md4) de l'inverseur de sources, et
- des sorties (32, 33) pour commander un état ouvert ou fermé de commutateurs (4, 5) destinés à connecter les sources d'énergie électrique (1, 2) à une ou plusieurs charges (8),
le procédé étant **caractérisé en ce qu'**il comporte :
- une étape d'identification (100) de toutes les combinaisons possibles des modes de fonctionnement (Md1 à Md4) et des états de disponibilité possibles des sources d'énergie (Vi10, Vi20), et
- une étape d'association (101) consistant à associer une configuration unique d'état ouvert ou fermé de chaque commutateur (4, 5) à chaque combinaison identifiée à l'étape d'identification (100) ;
- une étape (102) :
- de lecture d'un mode de fonctionnement opérationnel (Md) choisi parmi les modes de fonctionnement possibles (Md1 à Md4), et
- de lecture des états de disponibilité (Vi10, Vi20) des sources d'énergie (1, 2) ;
- une étape (103) de surveillance d'un changement de mode de fonctionnement opérationnel (Md) ou d'un changement d'état de disponibilité d'une ou plusieurs sources d'énergie (Vi10, Vi20)
**en ce que**, dans le cas d'un changement de mode de fonctionnement opérationnel (Md) ou d'un changement d'état de disponibilité d'une ou plusieurs sources d'énergie (Vi10, Vi20), le procédé effectue une étape (104) de commande des sorties (32, 33) pour mettre les commutateurs (4, 5) dans la configuration associée à la nouvelle combinaison du mode de fonctionnement opérationnel (Md) et de l'état des sources d'énergie (Vi10, Vi20),
dans lequel les modes de fonctionnement possibles (Md1 à Md4) de l'inverseur de sources comportent les modes de fonctionnement suivants :
un premier mode de fonctionnement (Md1) dit « mode automatique » dans lequel l'inverseur de sources bascule automatiquement dans la configuration dans laquelle les deux commutateurs sont ouverts quand la source n'est plus disponible et bascule automatiquement dans la configuration dans laquelle le premier commutateur (4) est fermé et le deuxième commutateur (5) est ouvert quand la première source est à nouveau disponible,
- un deuxième mode de fonctionnement (Md2) dit « mode secours forcé » dans lequel l'inverseur de sources bascule dans la configuration dans laquelle le premier commutateur (4) est fermé et le deuxième commutateur (5) est ouvert et reste dans cette configuration indépendamment de la disponibilité des sources (1, 2) ;
- un troisième mode de fonctionnement (Md3) dit « mode maintenance » dans lequel l'inverseur de sources bascule dans la configuration dans laquelle les deux commutateurs (4, 5) sont ouverts et reste dans cette configuration indépendamment de la disponibilité des sources, et
un quatrième mode de fonctionnement (Md4) dit « mode couplage » dans lequel l'inverseur de sources bascule dans la configuration dans laquelle les deux commutateurs (4, 5) sont fermés c'est-à-dire avec ladite charge connectée simultanément aux sources.

2. Procédé de contrôle d'un inverseur de sources selon la revendication 1 ledit inverseur de sources comportant en outre des entrées pour recevoir des états réels (Vi40, Vi50) des commutateurs (4, 5),
le procédé étant **caractérisé en ce que**, en l'absence de changement de mode de fonctionnement opérationnel (Md) et en l'absence de changement d'état de disponibilité d'une ou plusieurs sources d'énergie (Vi10, Vi20), ledit procédé comporte une étape (105) de contrôle de conformité, destinée à contrôler la conformité entre la configuration d'état ouvert ou fermé de chaque commutateur (4, 5) et l'état réel (Vi40, Vi50) desdits commutateurs.

3. Procédé de contrôle d'un inverseur de sources selon la revendication 2 **caractérisé en ce que**, dans le cas d'une non-conformité entre la configuration d'état de chaque commutateur (4, 5) et l'état réel desdits commutateurs (Vi40, Vi50), alors ledit procédé comporte une étape (107) supplémentaire d'information et de demande de validation par l'opérateur pour retourner à l'étape (104) de commande des sorties (32, 33).

4. Procédé de contrôle d'un inverseur de sources selon l'une des revendications précédentes ledit inverseur comportant en outre des entrées (Vf) pour recevoir des états de défaut, ledit procédé étant **caractérisé en ce qu'**il comporte une étape (106) de détection de présence d'au moins un état de défaut.

5. Procédé de contrôle d'un inverseur de sources selon la revendication 4 **caractérisé en ce que**, dans le cas de la présence d'au moins un état de défaut, il comporte une étape (108) d'aide à l'opérateur pour le diagnostic du défaut.

6. Procédé de contrôle d'un inverseur de sources selon la revendication 5 **caractérisé en ce que** l'étape (108) d'aide à l'opérateur pour le diagnostic du défaut consiste à mettre à disposition de l'opérateur au moins les informations de l'état des sources d'énergie (Vi10, Vi20), du mode de fonctionnement opérationnel (Md), de l'état réel des commutateurs (Vi40, Vi50), et du ou des états de défaut.

7. Procédé de contrôle d'un inverseur de sources selon la revendication 6 **caractérisé en ce que** l'étape (108) d'aide au diagnostic est exécutée tant qu'un état de défaut est présent.

8. Procédé de contrôle d'un inverseur de sources selon la revendication 7 **caractérisé en ce que** l'étape de contrôle de conformité (105) est exécutée quand tous les états de défaut ont disparu.

9. Procédé de contrôle d'un inverseur de sources selon l'une des revendications précédentes **caractérisé en ce qu'**il est mis en œuvre dans un dispositif de test comportant :
- des connexions pour recevoir des signaux simulant des états de disponibilité (Vi20, Vi30) des sources d'énergie (1,2),
- des connexions pour recevoir des signaux simulant des états (Vi40, Vi50) des commutateurs (4, 5),
- des connexions pour recevoir des signaux simulant des états de défaut (Vf),
- des connexions pour émettre des signaux vers des sorties (32,33) simulant une commande des commutateurs (4, 5) destinés à connecter des sources d'énergie électrique à la ou les charges (8),
- une interface opérateur (31) destinée à afficher des messages et sélectionner un mode de fonctionnement opérationnel (Md) parmi plusieurs modes de fonctionnement possibles (Md1 à Md4), et
- une unité de traitement de données (35) comportant :
- un ou plusieurs circuits (36) pour actionner l'interface opérateur (31),
- un ou plusieurs circuits (37) pour faire l'acquisition des signaux simulant les états (Vi40, Vi50) des commutateurs (4, 5),
- un ou plusieurs circuits (41) pour faire l'acquisition des signaux simulant les états de disponibilité (Vi20, Vi30) des sources d'énergie,
- un ou plusieurs circuits (38) pour faire l'acquisition des signaux simulant les états de défaut (Vf),
- un ou plusieurs circuits (40) pour exécuter les étapes du procédé, et
- un ou plusieurs circuits (39) pour émettre des signaux pour activer des sorties de commande (32, 33).

10. Procédé de contrôle d'un inverseur de sources selon la revendication 9 **caractérisé en ce que** :
- les signaux simulant des états de disponibilité (Vi20, Vi30) des sources d'énergie (1,2), les signaux simulant des états (Vi40, Vi50) des commutateurs (4, 5) et les signaux simulant des états de défaut (Vf) sont fournis par des moyens électriques ou informatiques activés par un opérateur, et
- les signaux vers des sorties (32,33) simulant une commande des commutateurs (4, 5) activent un dispositif d'affichage d'état,

11. Procédé de contrôle d'un inverseur de sources selon la revendication 10 **caractérisé en ce que** les signaux simulant le mode de fonctionnement (Md), les états de disponibilité (Vi20, Vi30) des sources d'énergie (1,2), les signaux simulant des états (Vi40, Vi50) des commutateurs (4, 5) et les signaux simulant des états de défaut (Vf) sont fournis selon des scénarios préenregistrés ou générés au moyen de fonctions aléatoires.

12. Procédé de contrôle d'un inverseur de sources selon la revendication 11 **caractérisé en ce que** les signaux simulant les états et les signaux vers les sorties (32,33) sont représentés de manière graphique sur l'interface opérateur (31).

13. Inverseur de sources mettant en œuvre le procédé selon les revendications 1 à 8, ledit inverseur étant **caractérisé en ce qu'**il comporte :
- des entrées configurées pour recevoir des états de disponibilité (Vi20, Vi30) des sources d'énergie,
- des entrées configurées pour recevoir des états réels (Vi40, Vi50) des commutateurs (4, 5),
- des entrées configurées pour recevoir des états de défaut (Vf),
- des sorties (32,33) configurées pour commander les commutateurs destinés à connecter des sources d'énergie électrique à la ou les charges (8),
- une interface opérateur (31) configurée pour à afficher des messages et sélectionner un mode de fonctionnement opérationnel (Md) parmi plusieurs modes de fonctionnement possibles (Md1 à Md4), et
- une unité de traitement de données (35) comportant :
- un ou plusieurs circuits (36) configurés pour actionner l'interface opérateur (31),
- un ou plusieurs circuits (37) configurés pour faire l'acquisition des états réel (Vi40, Vi50) des commutateurs (4, 5),
- un ou plusieurs circuits (41) configurés pour faire l'acquisition des états de disponibilité (Vi20, Vi30) des sources d'énergie,
- un ou plusieurs circuits (38) configurés pour faire l'acquisition des états de défaut (Vf)
- un ou plusieurs circuits (40) configurés pour exécuter les étapes du procédé, et
- un ou plusieurs circuits (39) configurés pour activer les sorties de commande (32, 33),
dans lequel les modes de fonctionnement possibles (Md1 à Md4) de l'inverseur de sources comportent les modes de fonctionnement suivants :
un premier mode de fonctionnement (Md1) dit « mode automatique » dans lequel l'inverseur de sources bascule automatiquement dans la configuration dans laquelle les deux commutateurs sont ouverts quand la source n'est plus disponible et bascule automatiquement dans la configuration dans laquelle le premier commutateur (4) est fermé et le deuxième commutateur (5) est ouvert quand la première source est à nouveau disponible,
- un deuxième mode de fonctionnement (Md2) dit « mode secours forcé » dans lequel l'inverseur de sources bascule dans la configuration dans laquelle le premier commutateur (4) est fermé et le deuxième commutateur (5) est ouvert et reste dans cette configuration indépendamment de la disponibilité des sources (1, 2) ;
- un troisième mode de fonctionnement (Md3) dit « mode maintenance » dans lequel l'inverseur de sources bascule dans la configuration dans laquelle les deux commutateurs (4, 5) sont ouverts et reste dans cette configuration indépendamment de la disponibilité des sources, et
un quatrième mode de fonctionnement (Md4) dit « mode couplage » dans lequel l'inverseur de sources bascule dans la configuration dans laquelle les deux commutateurs (4, 5) sont fermés c'est-à-dire avec ladite charge connectée simultanément aux sources.

## Patentansprüche

1. Verfahren zur Steuerung eines Wechselrichters elektrischer Energiequellen (3) zum Speisen einer oder mehrerer Lasten (8), der Wechselrichter umfassend:
- Eingänge zum Empfangen von Verfügbarkeitszuständen (Vi10, Vi20) von mehreren Energiequellen (1, 2),
- Eingänge zum Empfangen möglicher Betriebsmodi (Md1 bis Md4) des Wechselrichters von Quellen, und
- Ausgänge (32, 33) zum Steuern eines offenen oder geschlossenen Zustands von Schaltern (4, 5), die dazu bestimmt sind, die Quellen elektrischer Energie (1, 2) mit einer oder mehreren Lasten (8) zu verbinden,
wobei das Verfahren **dadurch gekennzeichnet ist, dass** es Folgendes umfasst:
- einen Schritt eines Identifizierens (100) aller möglichen Kombinationen von Betriebsmodi (Md1 bis Md4) und der möglichen Verfügbarkeitszustände der Energiequellen (Vi10, Vi20), und
- einen Assoziierungsschritt (101), der darin besteht, eine eindeutige Konfiguration des offenen oder geschlossenen Zustands von jedem Schalter (4, 5) mit jeder Kombination zu assoziieren, die in dem Identifizierungsschritt (100) identifiziert wird;
- einen Schritt (102):
- eines Lesens eines funktionierenden Betriebsmodus (Md), der aus den möglichen Betriebsmodi (Md1 bis Md4) ausgewählt ist, und
- Ablesen der Verfügbarkeitszustände (Vi10, Vi20) der Energiequellen (1, 2);
- einen Schritt (103) eines Überwachens einer Änderung des funktionierenden Betriebsmodus (Md) oder einer Änderung des Verfügbarkeitszustands von einer oder mehreren Energiequellen (Vi10, Vi20)
dass das Verfahren im Fall einer Änderung des Betriebsmodus (Md) oder einer Änderung des Verfügbarkeitszustands von einer oder mehreren Energiequellen (Vi10, Vi20) einen Schritt (104) eines Steuerns der Ausgänge (32, 33) durchführt, um die Schalter (4, 5) in die Konfiguration zu bringen, die mit der neuen Kombination des Betriebsmodus (Md) und des Zustands der Energiequellen (Vi10, Vi20) assoziiert ist,
wobei die möglichen Betriebsmodi (Md1 bis Md4) des Wechselrichters von Quellen die folgenden Betriebsmodi umfassen:
einen ersten Betriebsmodus (Md1), der als "automatischer Modus" bezeichnet wird, in dem der Wechselrichter von Quellen automatisch in die Konfiguration umschaltet, in der die zwei Schalter offen sind, wenn die Quelle nicht mehr verfügbar ist, und automatisch in die Konfiguration umschaltet, in der der erste Schalter (4) geschlossen und der zweite Schalter (5) geöffnet ist, wenn die erste Quelle wieder verfügbar ist,
- einen zweiten Betriebsmodus (Md2), der als "erzwungener Notfallmodus" bezeichnet wird, in dem der Wechselrichter von Quellen in die Konfiguration umschaltet, in der der erste Schalter (4) geschlossen ist und der zweite Schalter (5) geöffnet ist, und unabhängig von der Verfügbarkeit der Quellen (1, 2) in dieser Konfiguration bleibt;
- einen dritten Betriebsmodus (Md3), der als "Wartungsmodus" bezeichnet wird, in dem der Wechselrichter von Quellen in die Konfiguration umschaltet, in der die zwei Schalter (4, 5) geöffnet sind, und unabhängig von der Verfügbarkeit der Quellen in dieser Konfiguration bleibt, und
einen vierten Betriebsmodus (Md4), der als "Kopplungsmodus" bezeichnet wird, in dem der Wechselrichter von Quellen in die Konfiguration umschaltet, in der die zwei Schalter (4, 5) geschlossen sind, d. h. wobei die Last gleichzeitig mit den Quellen verbunden ist.

2. Steuerverfahren eines Wechselrichters von Quellen nach Anspruch 1 wobei der Wechselrichter von Quellen ferner Eingänge zum Empfangen von Ist-Zuständen (Vi40, Vi50) der Schalter (4, 5) umfasst,
wobei das Verfahren **dadurch gekennzeichnet ist, dass** bei Abwesenheit einer Änderung des funktionierenden Betriebsmodus (Md) und bei Abwesenheit einer Änderung des Verfügbarkeitszustands von einer oder mehreren Energiequellen (Vi10, Vi20) das Verfahren einen Schritt (105) einer Konformitätsprüfung umfasst, der dazu dient, die Konformität zwischen der Konfiguration des offenen oder geschlossenen Zustands von jedem Schalter (4, 5) und dem Ist-Zustand (Vi40, Vi50) der Schalter zu prüfen.

3. Steuerverfahren eines Wechselrichters von Quellen nach Anspruch 2, **dadurch gekennzeichnet, dass** im Falle einer Nichtkonformität zwischen der Zustandskonfiguration von jedem Schalter (4, 5) und dem Ist-Zustand der Schalter (Vi40, Vi50), das Verfahren dann einen zusätzlichen Schritt (107) von Information und Anforderung einer Validierung durch den Bediener umfasst, um zu dem Schritt (104) eines Steuerns der Ausgänge (32, 33) zurückzukehren.

4. Steuerverfahren eines Wechselrichters von Quellen nach einem der vorherigen Ansprüche, wobei der Wechselrichter ferner Eingänge (Vf) zum Empfangen von Fehlerzuständen umfasst, wobei das Verfahren **dadurch gekennzeichnet ist, dass** es einen Schritt (106) eines Erfassens eines Vorhandenseins mindestens eines Fehlerzustands umfasst.

5. Steuerverfahren eines Wechselrichters von Quellen nach Anspruch 4, **dadurch gekennzeichnet, dass** es im Falle des Vorhandenseins mindestens eines Fehlerzustands einen Schritt (108) eines Unterstützens des Bedieners bei der Fehlerdiagnose umfasst.

6. Steuerverfahren eines Wechselrichters von Quellen nach Anspruch 5, **dadurch gekennzeichnet, dass** der Schritt (108) zum Unterstützen des Bedieners bei der Fehlerdiagnose darin besteht, dem Bediener zumindest die Informationen des Zustands der Energiequellen (Vi10, Vi20), des Betriebsmodus (Md), des Ist-Zustands der Schalter (Vi40, Vi50) und des Fehlerzustands bzw. der Fehlerzustände bereitzustellen.

7. Steuerverfahren eines Wechselrichters von Quellen nach Anspruch 6, **dadurch gekennzeichnet, dass** der Schritt (108) eines Unterstützens bei der Diagnose ausgeführt wird, solange ein Fehlerzustand vorhanden ist.

8. Steuerverfahren eines Wechselrichters von Quellen nach Anspruch 7, **dadurch gekennzeichnet, dass** der Schritt einer Konformitätsprüfung (105) ausgeführt wird, wenn alle Fehlerzustände aufgehoben wurden.

9. Steuerverfahren eines Wechselrichters von Quellen nach einem der vorherigen Ansprüche, **dadurch gekennzeichnet, dass** es in einer Testvorrichtung implementiert ist, umfassend:
- Verbindungen zum Empfangen von Signalen, die Verfügbarkeitszustände (Vi20, Vi30) der Energiequellen (1, 2) simulieren,
- Verbindungen zum Empfangen von Signalen, die Zustände (Vi40, Vi50) der Schalter (4, 5) simulieren,
- Verbindungen zum Empfangen von Signalen, die Fehlerzustände (Vf) simulieren,
- Verbindungen zum Ausgeben von Signalen an Ausgänge (32, 33), die eine Steuerung der Schalter (4, 5) simulieren, die dazu bestimmt sind, Quellen elektrischer Energie mit der oder Lasten (8) zu verbinden,
- eine Bedieneroberfläche (31), die dazu bestimmt ist, Meldungen anzuzeigen und einen Betriebsmodus (Md) aus mehreren möglichen Betriebsmodi (Md1 bis Md4) auszuwählen, und
- eine Datenverarbeitungseinheit (35), umfassend:
- eine oder mehrere Schaltungen (36) zum Betätigen der Bedieneroberfläche (31),
- eine oder mehrere Schaltungen (37) zum Erfassen der Signale, die die Zustände (Vi40, Vi50) der Schalter (4, 5) simulieren,
- eine oder mehrere Schaltungen (41) zum Erfassen der Signale, die die Verfügbarkeitszustände (Vi20, Vi30) der Energiequellen simulieren,
- eine oder mehrere Schaltungen (38) zum Erfassen der Signale, die die Fehlerzustände (Vf) simulieren,
- eine oder mehrere Schaltungen (40), um die Schritte des Verfahrens auszuführen, und
- eine oder mehrere Schaltungen (39) zum Ausgeben von Signalen zum Aktivieren der Steuerausgänge (32, 33).

10. Steuerverfahren eines Wechselrichters von Quellen nach Anspruch 9, **dadurch gekennzeichnet, dass**:
- die Signale, die Verfügbarkeitszustände (Vi20, Vi30) der Energiequellen (1, 2) simulieren, die Signale, die Zustände (Vi40, Vi50) der Schalter (4, 5) simulieren, und die Signale, die Fehlerzustände (Vf) simulieren, von elektrischen oder Informatikeinrichtungen geliefert werden, die von einem Bediener aktiviert werden, und
- die Signale zu Ausgängen (32, 33), die eine Steuerung der Schalter (4, 5) simulieren, eine Zustandsanzeigevorrichtung aktivieren,

11. Steuerverfahren eines Wechselrichters von Quellen nach Anspruch 10, **dadurch gekennzeichnet, dass** die Signale, die den Betriebsmodus (Md), die Verfügbarkeitszustände (Vi20, Vi30) der Energiequellen (1, 2), die Signale, die Zustände (Vi40, Vi50) der Schalter (4, 5) simulieren, und die Signale, die Fehlerzustände (Vf) simulieren, gemäß voraufgezeichneten Szenarien geliefert oder mittels Zufallsfunktionen erzeugt werden.

12. Steuerverfahren eines Wechselrichters von Quellen nach Anspruch 11, **dadurch gekennzeichnet, dass** die Signale, die die Zustände simulieren, und die Signale zu den Ausgängen (32, 33) grafisch auf der Bedieneroberfläche (31) dargestellt werden.

13. Wechselrichter von Quellen, der das Verfahren nach den Ansprüchen 1 bis 8 implementiert, wobei der Wechselrichter **dadurch gekennzeichnet ist, dass** er Folgendes umfasst:
- Eingänge, die konfiguriert sind, um Verfügbarkeitszustände (Vi20, Vi30) der Energiequellen zu empfangen,
- Eingänge, die konfiguriert sind, um Ist-Zustände (Vi40, Vi50) der Schalter (4, 5) zu empfangen,
- Eingänge, die konfiguriert sind, um Fehlerzustände (Vf) zu empfangen,
- Ausgänge (32, 33), die konfiguriert sind, um die Schalter zu steuern, die dazu bestimmt sind, Quellen elektrischer Energie mit der oder den Lasten (8) zu verbinden,
- eine Bedieneroberfläche (31), die konfiguriert ist, um Meldungen anzuzeigen und einen Betriebsmodus (Md) aus mehreren möglichen Betriebsmodi (Md1 bis Md4) auszuwählen, und
- eine Datenverarbeitungseinheit (35), umfassend:
- eine oder mehrere Schaltungen (36), die konfiguriert sind, um die Bedieneroberfläche (31) zu betätigen,
- eine oder mehrere Schaltungen (37), die konfiguriert sind, um die Ist-Zustände (Vi40, Vi50) der Schalter (4, 5) zu erfassen,
- eine oder mehrere Schaltungen (41), die konfiguriert sind, um die Verfügbarkeitszustände (Vi20, Vi30) der Energiequellen zu erfassen,
- eine oder mehrere Schaltungen (38), die konfiguriert sind, um die Fehlerzustände (Vf) zu erfassen,
- eine oder mehrere Schaltungen (40), die konfiguriert sind, um die Schritte des Verfahrens auszuführen, und
- eine oder mehrere Schaltungen (39), die konfiguriert sind, um die Steuerausgänge (32, 33) zu aktivieren,
wobei die möglichen Betriebsmodi (Md1 bis Md4) des Wechselrichters von Quellen die folgenden Betriebsmodi umfassen:
einen ersten Betriebsmodus (Md1), der als "automatischer Modus" bezeichnet wird, in dem der Wechselrichter von Quellen automatisch in die Konfiguration umschaltet, in der die zwei Schalter offen sind, wenn die Quelle nicht mehr verfügbar ist, und automatisch in die Konfiguration umschaltet, in der der erste Schalter (4) geschlossen und der zweite Schalter (5) geöffnet ist, wenn die erste Quelle wieder verfügbar ist,
- einen zweiten Betriebsmodus (Md2), der als "erzwungener Notfallmodus" bezeichnet wird, in dem der Wechselrichter von Quellen in die Konfiguration umschaltet, in der der erste Schalter (4) geschlossen ist und der zweite Schalter (5) geöffnet ist, und unabhängig von der Verfügbarkeit der Quellen (1, 2) in dieser Konfiguration bleibt;
- einen dritten Betriebsmodus (Md3), der als "Wartungsmodus" bezeichnet wird, in dem der Wechselrichter von Quellen in die Konfiguration umschaltet, in der die zwei Schalter (4, 5) geöffnet sind, und unabhängig von der Verfügbarkeit der Quellen in dieser Konfiguration bleibt, und
- einen vierten Betriebsmodus (Md4), der als "Kopplungsmodus" bezeichnet wird, in dem der Wechselrichter von Quellen in die Konfiguration umschaltet, in der die zwei Schalter (4, 5) geschlossen sind, d. h. wobei die Last gleichzeitig mit den Quellen verbunden ist.

## Claims

1. A method of controlling an inverter of electrical energy sources (3) for supplying one or more loads (8), said inverter comprising:
- inputs for receiving availability states (Vi10, Vi20) of several energy sources (1, 2),
- inputs for receiving possible operating modes (Md1 to Md4) of the source inverter, and
- outputs (32, 33) for controlling an open or closed state of switches (4, 5) for connecting the electrical power sources (1, 2) to one or more loads (8),
the method being **characterised in that** it comprises:
- a step of identifying (100) all possible combinations of the operating modes (Md1 to Md4) and the possible availability states of the energy sources (Vi10, Vi20), and
- a step of associating (101) consisting of associating a unique open or closed state configuration of each switch (4, 5) with each combination identified in the identification step (100);
- a step (102):
- of reading a functional operating mode (Md) selected from the possible operating modes (Md1 to Md4), and
- of reading the availability states (Vi10, Vi20) of the energy sources (1, 2);
- a step (103) of monitoring a change of functional operating mode (Md) or a change of availability status of one or more power sources (Vi10, Vi20) in that, in the event of a change in the functional operating mode (Md) or a change in the availability status of one or more power sources (Vi10, Vi20), the method performs a step (104) of commanding the outputs (32, 33) to set the switches (4, 5) to the configuration associated with the new combination of the functional operating mode (Md) and the status of the power sources (Vi10, Vi20),
wherein the possible operating modes (Md1 to Md4) of the source inverter comprise the following operating modes:
a first operating mode (Md1) called "automatic mode" in which the source inverter automatically switches to the configuration in which both switches are open when the source is no longer available and automatically switches to the configuration in which the first switch (4) is closed and the second switch (5) is open when the first source is available again,
- a second operating mode (Md2) known as "forced emergency mode" in which the source inverter switches to the configuration in which the first switch (4) is closed and the second switch (5) is open and remains in this configuration regardless of the availability of the sources (1, 2);
- a third operating mode (Md3) called "maintenance mode" in which the source inverter switches to the configuration in which both switches (4, 5) are open and remains in this configuration regardless of the availability of the sources, and
a fourth operating mode (Md4) known as "coupling mode" in which the source inverter switches to the configuration in which both switches (4, 5) are closed, i.e. with said load connected simultaneously to the sources.

2. The method of controlling a source inverter according to claim 1, said source inverter further comprising inputs for receiving actual states (Vi40, Vi50) of the switches (4, 5),
the method being **characterised in that**, in the absence of a change in operating mode (Md) and in the absence of a change in the availability state of one or more power sources (Vi10, Vi20), said method comprises a conformity check step (105), intended to check the conformity between the open or closed state configuration of each switch (4, 5) and the actual state (Vi40, Vi50) of said switches.

3. The method of controlling a source inverter according to claim 2, **characterised in that**, in the event of a non-conformity between the state configuration of each switch (4, 5) and the actual state of the said switches (Vi40, Vi50), then the said method comprises an additional step (107) of informing and requesting validation by the operator in order to return to the step (104) of commanding the outputs (32, 33).

4. The method of controlling a source inverter according to one of the preceding claims, said inverter further comprising inputs (Vf) for receiving fault states, said method being **characterised in that** it comprises a step (106) of detecting the presence of at least one fault state.

5. The method of controlling a source inverter according to claim 4, **characterised in that**, in the event of the presence of at least one fault state, it comprises a step (108) of helping the operator diagnose the fault.

6. The method of controlling a source inverter according to claim 5, **characterised in that** the step (108) of assisting the operator in diagnosing the fault consists of making available to the operator at least the information of the state of the energy sources (Vi10, Vi20), the functional operating mode (Md), the actual state of the switches (Vi40, Vi50), and the fault state(s).

7. The method of controlling a source inverter according to claim 6, **characterised in that** the diagnostic support step (108) is performed as long as a fault state is present.

8. The method of controlling a source inverter according to claim 7, **characterised in that** the conformity check step (105) is performed when all fault states have disappeared.

9. The method of controlling a source inverter according to one of the preceding claims, **characterised in that** it is implemented in a test device comprising:
- connections for receiving signals simulating availability states (Vi20, Vi30) of the power sources (1, 2),
- connections for receiving signals simulating states (Vi40, Vi50) of the switches (4, 5),
- connections for receiving signals simulating fault states (Vf),
- connections for sending signals to outputs (32, 33) simulating control of switches (4, 5) for connecting sources of electrical power to the load(s) (8),
- an operator interface (31) for displaying messages and selecting a functional operating mode (Md) from a number of possible operating modes (Md1 to Md4), and
- a data processing unit (35) comprising:
- one or more circuits (36) for actuating the operator interface (31),
- one or more circuits (37) for acquiring signals simulating the states (Vi40, Vi50) of the switches (4, 5),
- one or more circuits (41) for acquiring signals simulating the availability states (Vi20, Vi30) of the energy sources,
- one or more circuits (38) for acquiring the signals simulating the fault states (Vf),
- one or more circuits (40) for carrying out the steps of the method, and
- one or more circuits (39) for generating signals to activate command outputs (32, 33).

10. The method of controlling a source inverter according to claim 9, **characterised by** that:
- the signals simulating availability states (Vi20, Vi30) of the power sources (1, 2), the signals simulating states (Vi40, Vi50) of the switches (4, 5) and the signals simulating fault states (Vf) are provided by electrical or computer means activated by an operator, and
- the signals to outputs (32, 33) simulating a control of the switches (4, 5) activate a status display device.

11. The method of controlling a source inverter according to claim 10 **characterised in that** the signals simulating the operating mode (Md), the availability states (Vi20, Vi30) of the power sources (1, 2), the signals simulating states (Vi40, Vi50) of the switches (4, 5) and the signals simulating fault states (Vf) are provided according to prerecorded scenarios or scenarios generated by means of random functions.

12. The method of controlling a source inverter according to claim 11 **characterised in that** the signals simulating the states and the signals to the outputs (32, 33) are represented graphically on the operator interface (31).

13. The source inverter implementing the method according to claims 1 to 8, said inverter being **characterised in that** it comprises:
- inputs configured to receive availability states (Vi20, Vi30) of the power sources,
- inputs configured to receive actual states (Vi40, Vi50) of the switches (4, 5),
- inputs configured to receive fault states (Vf),
- outputs (32, 33) configured to command switches for connecting electrical power sources to the load(s) (8),
- an operator interface (31) configured to display messages and select a functional operating mode (Md) from a number of possible operating modes (Md1 to Md4), and
- a data processing unit (35) comprising:
- one or more circuits (36) configured to actuate the operator interface (31),
- one or more circuits (37) configured to acquire the actual states (Vi40, Vi50) of the switches (4, 5),
- one or more circuits (41) configured to acquire the availability states (Vi20, Vi30) of the energy sources,
- one or more circuits (38) configured to acquire fault states (Vf),
- one or more circuits (40) configured to carry out the steps of the method, and
- one or more circuits (39) configured to activate the command outputs (32, 33),
wherein the possible operating modes (Md1 to Md4) of the source inverter comprise the following operating modes:
a first operating mode (Md1) called "automatic mode" in which the source inverter automatically switches to the configuration in which both switches are open when the source is no longer available and automatically switches to the configuration in which the first switch (4) is closed and the second switch (5) is open when the first source is available again,
- a second operating mode (Md2) known as "forced emergency mode" in which the source inverter switches to the configuration in which the first switch (4) is closed and the second switch (5) is open and remains in this configuration regardless of the availability of the sources (1, 2);
- a third operating mode (Md3) called "maintenance mode" in which the source inverter switches to the configuration in which both switches (4, 5) are open and remains in this configuration regardless of the availability of the sources, and
- a fourth operating mode (Md4) known as "coupling mode" in which the source inverter switches to the configuration in which both switches (4, 5) are closed, i.e. with said load connected simultaneously to the sources.
